# FASCICULE DE BREVET EUROPEEN

(11) **EP 2 076 925 B1**
(45) Date de publication et mention de la délivrance du brevet: **11.07.2018**
(21) Numéro de dépôt: 07821139.8
(22) Date de dépôt: 10.10.2007
(51) Int. Cl.: H01L 27/146

(54) **DISPOSITIF DE COUPLAGE ELECTROMAGNETIQUE D'UN DETECTEUR DE RAYONNEMENT ELECTROMAGNETIQUE.**
EINRICHTUNG ZUM ELEKTROMAGNETISCHEN KOPPELN EINES ELEKTROMAGNETISCHEN STRAHLUNGSSENSORS
DEVICE FOR ELECTROMAGNETICALLY COUPLING AN ELECTROMAGNETIC RADIATION SENSOR

(30) Priorité: 12.10.2006 FR 0654235
(43) Date de publication de la demande: 08.07.2009
(73) Titulaire: Commissariat à l'Énergie Atomique et aux Énergies Alternatives, 75015 Paris (FR)
(72) Inventeur: ROSTAING, Jean-Pierre, 38260 La Cote Saint-andre (FR); BILLOINT, Olivier, 38000 Grenoble (FR); OUVRIER-BUFFET, Patrice, 74410 Saint-jorioz (FR); VILLARD, Patrick, 38700 La Tronche (FR)
(74) Mandataire: Ilgart, Jean-Christophe
(86) Numéro de dépôt international: PCT/EP2007/060771
(87) Numéro de publication internationale: WO 2008/043786

(56) Documents cités:
- EP-A- 1 122 790
- EP-A2- 0 214 408
- EP-A2- 1 102 321
- WO-A-2004/001853
- WO-A-2004/021402
- FR-A- 2 888 667
- JP-A- 5 013 748
- US-A1- 2004 266 053

## Description

### DOMAINE TECHNIQUE

La présente invention concerne le domaine de la microélectronique et plus particulièrement celui des détecteurs de rayonnement électromagnétiques associés ou assemblés à au moins un circuit intégré comprenant un dispositif électronique de traitement des signaux issus du détecteur.

### ART ANTÉRIEUR

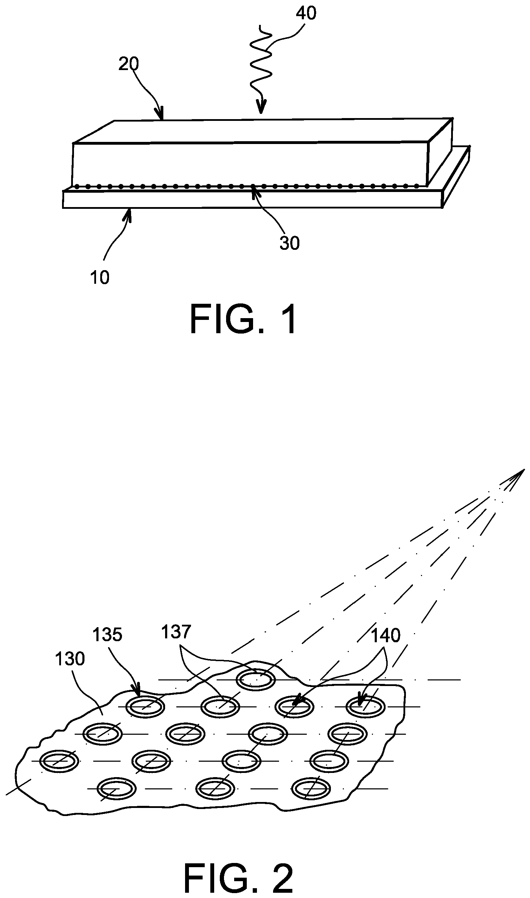

La figure 1 illustre un exemple de dispositif microélectronique suivant l'art antérieur, comprenant un détecteur 20 de rayonnement électromagnétique, connecté par l'intermédiaire de connexions métalliques 30 à un circuit électronique 10 de traitement de signaux issus de l'interaction des photons 40 dans le matériau du détecteur. Dans le circuit électronique 10, certaines zones correspondant par exemple à des étages numériques ou à des composants numériques susceptibles d'effectuer des traitements massifs de données, produisent des perturbations électromagnétiques, qui peuvent s'avérer non négligeables par rapport au signal utile en provenance du détecteur 20 et éventuellement supérieures au signal utile du détecteur 20.

Le document EP 0 214 408 décrit un dispositif dispositif microélectronique (figures 1 et 2) comprenant un détecteur de rayonnement électromagnétique (16, 15, 14, 11) assemblé et connecté à un circuit intégré (1), le circuit intégré comprenant un dispositif (2, 3, 4, 5) de traitement de signaux issus du détecteur, le dispositif de traitement étant recouvert d'au moins une couche métallique de protection (9) vis-à-vis de rayonnement électromagnétique, placée entre ledit détecteur et ledit dispositif de traitement (figure 1), ladite couche métallique comportant une ou plusieurs ouvertures.

### EXPOSE DE L'INVENTION

L'invention concerne tout d'abord un circuit intégré selon la revendication 1, destiné à être assemblé à un détecteur de rayonnement électromagnétique, le circuit intégré comprenant un dispositif de traitement de signaux issus du détecteur, le dispositif de traitement étant recouvert d'au moins une couche métallique, ladite couche métallique comportant une ou plusieurs ouvertures à travers lesquelles passent des plots conducteurs permettant une connexion électrique entre le dispositif de traitement et le détecteur.

La couche métallique sert notamment de protection vis-à-vis dudit rayonnement électromagnétique.

La couche métallique a un agencement permettant de remplir un tel rôle de protection.

La couche métallique peut être placée dans la partie supérieure du circuit intégré. Le détecteur de rayonnement électromagnétique est alors placé sur le circuit intégré, de sorte que ladite couche métallique soit placée entre ledit circuit et le détecteur.

Selon une possibilité de mise en oeuvre du circuit intégré, ce dernier peut comprendre des moyens de polarisation de ladite couche métallique Selon une possibilité de mise en oeuvre du circuit intégré, ladite couche métallique peut être placée en surface du circuit intégré, chaque plot conducteur comprenant un plot de connexion placé en surface du circuit intégré.

Le circuit intégré peut comprendre un substrat semi-conducteur, le dispositif de traitement de signaux comprenant des composants électriques formés dans et au-dessus du substrat semi-conducteur. Au niveau des ouvertures de la couche métallique, lesdits éléments conducteurs sont séparés de ladite couche métallique d'un espace prévu pour permettre un couplage capacitif. Cela peut permettre d'effectuer un test du circuit intégré.

L'invention concerne également un dispositif microélectronique comprenant un détecteur de rayonnement électromagnétique assemblé et connecté à un circuit intégré tel que défini plus haut.

L'invention concerne également un procédé de test d'un tel circuit intégré comprenant les étapes suivantes :
- appliquer une tension variable sur ladite couche conductrice, et
- vérifier le fonctionnement du dispositif de traitement de signaux.

### BRÈVE DESCRIPTION DES DESSINS

D'autres objectifs, caractéristiques et avantages de l'invention apparaîtront à la lecture de la description détaillée ci-après, de modes de réalisation de l'invention, faite à titre d'exemple non limitatif, en regard des dessins annexés sur lesquels :
- la figure 1 représente un détecteur de rayonnement électromagnétique assemblé et connecté à un circuit intégré comprenant un dispositif de traitement de signaux issus du détecteur,
- la figure 2 illustre une couche métallique pouvant être utilisée dans un dispositif suivant l'invention,
- les figures 3A et 3B représentent, en vue en coupe, respectivement un premier mode de réalisation d'un dispositif suivant l'invention et une variante qui ne fait pas partie de la présente invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de dispositif de protection et de test d'un circuit intégré selon l'invention est illustré sur la figure 2.

Ce dispositif comprend une zone conductrice de l'électricité destinée à être placée entre un détecteur de rayonnement électromagnétique et un circuit électronique de traitement de signaux issus du détecteur (non représentés sur cette figure). La zone conductrice peut être connectée à des moyens électriques de polarisation (non représentés) permettant d'appliquer au moins un potentiel électrique sur la zone conductrice.

La zone conductrice est sous forme d'une couche ou d'une plaque 130, à base d'un premier métal, par exemple de l'aluminium, destinée à former une première électrode.

La plaque 130 peut avoir une forme rectangulaire ou carré, par exemple de dimensions de l'ordre de 200 µm * 200 µm.

La couche ou plaque métallique 130 peut être constituée d'un métal couramment utilisé pour fabriquer les réseaux d'interconnexions d'un circuit intégré, tel que le cuivre ou l'aluminium. Afin de remplir au mieux son rôle de protection, en absorbant le plus possible de rayonnements électromagnétiques émis par le circuit intégré, la couche ou plaque 130 peut être constituée d'un matériau présentant une perméabilité magnétique élevée, tel qu'un matériau à base de fer, de nickel ou de cobalt. De même, plus l'épaisseur de la couche ou plaque est importante plus il est possible d'absorber des rayonnements électromagnétiques basses fréquences.

Dans le cas où la fréquence de fonctionnement du circuit intégré est de l'ordre de la dizaine ou de la centaine de MHz, une couche métallique en cuivre ou en aluminium ayant une épaisseur de 1 à 2 micromètres permet d'absorber une bonne partie des rayonnements électromagnétiques.

Dans cet exemple, la plaque métallique 130 est ajourée et comporte une pluralité d'ouvertures 135 dans lesquelles figurent respectivement au moins un plot conducteur 140 de l'électricité. Par plaque, on entend que la surface occupée par la couche métallique est supérieure à la surface totale occupée par les ouvertures. Cela permet à la plaque 130 de remplir au mieux son rôle de protection.

Les plots conducteurs 140 situés dans les ouvertures peuvent être à base d'un métal identique ou différent du premier métal, par exemple de l'aluminium, du cuivre ou du tungstène.

Les plots conducteurs 140 sont agencés de sorte qu'un espace 137, par exemple de l'ordre de 1 µm, vide ou rempli de matériau diélectrique, est prévu entre chaque plot conducteur 140 et la couche métallique 130. L'espace 137 entre chaque plot conducteur 140 et la couche métallique 130 est prévu suffisamment mince pour permettre un couplage capacitif.

Selon une possibilité, une capacité de couplage d'au moins 10 fF, par exemple de l'ordre de 40 fF peut être obtenue.

Dans un plan parallèle à la plaque 130, les plots conducteurs 140, peuvent avoir respectivement une surface de l'ordre par exemple de 625 µm².

Les plots conducteurs peuvent être prévus de manière à avoir, dans un plan parallèle à la plaque 130, une surface inférieure à 20 % ou à 10%, de préférence à 2%, de la surface totale de la plaque.

Les plots conducteurs peuvent avoir une forme carré ou rectangulaire ou octogonale. Selon une variante, des plots conducteurs cylindriques peuvent être prévus.

Les ouvertures 135 et les plots conducteurs 140 peuvent avoir une répartition régulière dans la couche métallique 130, et par exemple un agencement matriciel. Les ouvertures 135 ont une répartition prévue de sorte que l'espacement entre deux ouvertures est au moins 5 fois supérieur ou au moins 10 fois supérieur au diamètre des plots conducteurs 140.

Cela permet de rendre la capacité mutuelle nulle entre les plots conducteurs.

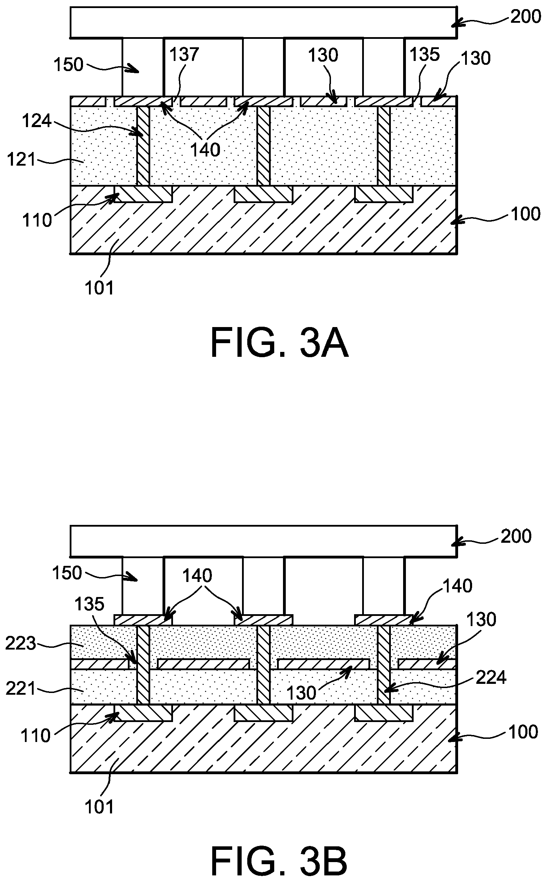

Les plots conducteurs 140 permettent de réaliser une interconnexion entre un détecteur 200 de rayonnement électromagnétique et un circuit intégré 100 comportant un dispositif de traitement de signaux provenant du détecteur, comme cela est décrit ci-après en relation avec les figures 3A et 3B.

Selon une possibilité de mise en oeuvre, les ouvertures 135 et les plots conducteurs 140 peuvent avoir des formes différentes.

Selon une première possibilité de mise en oeuvre des moyens de protection, des moyens électriques de polarisation peuvent être prévus pour appliquer à la couche conductrice 130, un potentiel électrique V fixe par rapport à un potentiel de référence du circuit électronique de traitement. Dans ce cas, la couche métallique 130 ajourée permet de former un écran électromagnétique vis-à-vis de perturbations en provenance du circuit intégré 100. Ce mode de fonctionnement est particulièrement intéressant lorsque le détecteur est en marche.

Selon une deuxième possibilité de mise en oeuvre, les moyens électriques de polarisation peuvent être prévus pour appliquer à la couche métallique 130, un potentiel v variable. Dans ce cas, la couche métallique 130 est susceptible de former une électrode de stimulation pour les plots 140 et permet d'appliquer respectivement à ces derniers une quantité de charge q=C*v avec C la capacité entre la couche métallique 130 formant une première électrode et un des plots conducteurs 140. Les charges appliquées sur les plots 140 peuvent être identiques.

Cette deuxième possibilité de mise en oeuvre peut s'avérer avantageuse en ce qui concerne le test et la calibration du circuit électronique 100 de traitement. Chaque capacité C peut être identique par construction. Les signaux électriques induits dans chaque plot sont alors identiques et connus. On peut, lors d'une phase de test, générer des signaux semblables à des signaux issus du détecteur. Des moyens de test du dispositif de traitement peuvent être mis en oeuvre pour vérifier si tous les signaux induits sont détectés et si une valeur de signal correcte est mesurée par le dispositif de traitement. Un tel test peut avantageusement être réalisé préalablement à l'assemblage d'un détecteur de rayonnement sur un circuit intégré selon l'invention.

Par ailleurs, on peut prévoir d'appliquer un potentiel v variable sur la plaque ou couche conductrice 130, lorsque le détecteur est en marche. L'application d'un signal alternatif sur la plaque 130 correspond à une opération de modulation des signaux provenant du détecteur. Une telle modulation permet d'améliorer le traitement ultérieur des signaux par le dispositif de traitement de signaux placé sur le circuit intégré 100.

La figure 3A illustre un exemple d'assemblage entre un détecteur 200 de rayonnement électromagnétique et un circuit intégré 100 comportant un dispositif de traitement de signaux issus du détecteur 200. Le détecteur 200 peut être prévu par exemple pour détecter l'un des rayonnements suivants : rayons X, rayons gamma, infra-rouge, visible. Le circuit intégré 100 peut être par exemple un ASIC (circuit intégré à application spécifique). Le dispositif de traitement est prévu notamment pour amplifier de faibles signaux issus de l'interaction entre des photons et le matériau du détecteur 200. Le circuit intégré 100 peut être formé sur un substrat 101 semi-conducteur, par exemple à base de silicium et être doté d'un ensemble de composants électroniques et d'interconnexions métalliques qui peuvent être agencées sur plusieurs niveaux et parmi lesquelles figurent des contacts 110 placés en surface du substrat 101. Sur la figure 3A, le substrat 101 est recouvert d'une couche isolante 121, à base d'un matériau diélectrique tel que par exemple du SiO₂, et dans laquelle sont placés des éléments conducteurs tels que des vias conducteurs 124 connectés par exemple à un contact 110 placé en surface du substrat 101. Les vias conducteurs 124 insérés dans la couche isolante 121 sont également connectés respectivement à au moins un plot de connexion 140 situé en surface du circuit intégré sur la couche isolante 121. Un contact métallique 150 est placé sur chaque plot de connexion 140 afin de connecter le détecteur 200 au circuit intégré. Des moyens pour protéger le détecteur 200 de perturbations électromagnétiques provenant du circuit électronique 100 sont prévus. Ces moyens comprennent une couche conductrice 130 ajourée comportant une pluralité d'ouvertures 135 dans lesquelles figurent respectivement au moins un plot de connexion 140 auquel au moins un contact du détecteur 200 et au moins un contact du circuit intégré 100 est relié. Les plots conducteurs 140 et la couche 130 conductrice sont situés dans un même plan qui est parallèle au plan principal du substrat 101. Les plots de connexion 140 sont séparés de la couche 130 par une épaisseur de matériau diélectrique.

La figure 3B illustre une variante qui ne fait pas partie de la présente invention et pour laquelle les plots de connexion 140 auxquels sont connectés au moins un contact du détecteur 200, sont situés dans un plan différent de celui de la couche métallique 130 ajourée. Dans cette variante de réalisation, la couche isolante 121 est remplacée par une première couche isolante 221 et une deuxième couche isolante 223 empilées, la plaque conductrice 130 étant placée sur la première couche isolante 221. Des vias conducteurs 224 sont placés dans lesdites ouvertures 135 de la plaque conductrice 130. Dans cet exemple de réalisation, les vias conducteurs 135 relient les plots de connexion 140 placés en surface du circuit intégré aux contacts 110 placés en surface du substrat 100.

On notera que les liaisons électriques entre les plots de connexion 140 et le dispositif de traitement peuvent avoir une toute autre forme que celle purement « verticale » représentée en figures 3A et 4A. De plus, les liaisons électriques ne sont pas nécessairement reliées à un contact placé sur le substrat 100. Elles peuvent par exemple être reliées à une grille de transistor.

Des moyens électriques de polarisation peuvent être prévus pour appliquer un potentiel électrique fixe V ou variable v à la couche métallique 130. Selon une possibilité de mise en oeuvre, les moyens de polarisation de la couche conductrice 130 sont placés dans le circuit intégré. Ces moyens de polarisation utilisent par exemple le réseau d'alimentation général du circuit intégré.

Selon une variante, des moyens de polarisation extérieurs au circuit intégré peuvent également être utilisés. Ces moyens de polarisation extérieurs peuvent être utilisés par exemple lorsque l'on souhaite tester le dispositif de traitement de signaux préalablement à l'assemblage du détecteur 200 sur le circuit intégré 100. Préalablement à un assemblage du détecteur et du circuit intégré, on peut également utiliser un dispositif de test, par exemple de type BIST (BIST ou « Build In Self Test » selon la terminologie anglo-saxonne) placé sur le circuit intégré. Un test préalable à l'assemblage permet de diminuer le nombre de dispositifs détecteurs/circuit intégré défectueux.

## Revendications

1. Circuit intégré (100), assemblé à un détecteur (200) de rayonnement électromagnétique, le circuit intégré comprenant un dispositif de traitement de signaux issus du détecteur, le dispositif de traitement étant recouvert d'au moins une couche métallique (130) de protection vis-à-vis de rayonnement électromagnétique, placée entre ledit détecteur et ledit dispositif de traitement, ladite couche métallique comportant une ou plusieurs ouvertures (135), la surface occupée par la couche métallique étant supérieure à la surface totale occupée par les ouvertures, des plots conducteurs (140), passant à travers les ouvertures, permettant une connexion électrique entre le dispositif de traitement et le détecteur, les plots conducteurs étant électriquement liés par des vias conducteurs (124) à des contacts du circuit intégré (100), les plots conducteurs étant électriquement liés au détecteur (200) par des contacts métalliques (150), dans lequel, au niveau des ouvertures (135) de la couche métallique lesdits plots conducteurs sont séparés de ladite couche métallique (130) d'un espace prévu suffisamment faible pour permettre un couplage capacitif entre les plots conducteurs et la couche métallique (130), **caractérisé en ce que** les ouvertures (135) ont une répartition prévue de sorte que l'espacement entre deux ouvertures est au moins 5 fois supérieur au diamètre des plots conducteurs (140) de sorte à rendre la capacité mutuelle nulle entre les plots conducteurs (140).

2. Circuit intégré selon la revendication 1, comprenant des moyens de polarisation de ladite couche métallique (130).

3. Circuit intégré selon la revendication 1 ou 2, dans lequel ladite partie supérieure du circuit intégré comprend au moins une couche isolante (121) dans laquelle lesdits plots conducteurs sont placés.

4. Circuit intégré selon l'une des revendications 1 à 3, dans lequel ladite couche métallique (130) de protection est placée en surface du circuit intégré, chaque plot conducteur de connexion (140) étant placé en surface du circuit intégré.

5. Circuit intégré selon l'une des revendications 1 à 4, comprenant un substrat semi-conducteur, le dispositif de traitement de signaux comprenant des composants électriques formés dans et au-dessus du substrat semi-conducteur.

6. Circuit intégré selon l'une des revendications 1 à 5, dans lequel lesdites ouvertures et les plots conducteurs placées dans ces ouvertures ont des formes sensiblement cylindriques.

7. Procédé de test d'un circuit intégré selon l'une des revendications 1 à 6, comprenant les étapes suivantes :
- appliquer une tension variable sur ladite couche métallique, et
- vérifier le fonctionnement du dispositif de traitement de signaux.

8. Procédé de détection de rayonnement électromagnétique au moyen d'un circuit intégré selon l'une des revendications 1 à 6, consistant à appliquer un potentiel fixe sur ladite couche métallique lors du fonctionnement du détecteur de rayonnement électromagnétique.

9. Procédé de détection de rayonnement électromagnétique au moyen d'un circuit intégré selon l'une des revendications 1 à 6, consistant à appliquer un potentiel variable sur ladite couche métallique lors du fonctionnement du détecteur de rayonnement pour moduler les signaux électriques délivrés par le détecteur de rayonnement électromagnétique.

## Patentansprüche

1. Integrierte Schaltung (100), die mit einem elektromagnetischen Strahlungsdetektor (200) zusammengefügt ist, wobei die integrierte Schaltung eine Signalverarbeitungsvorrichtung für Signale umfasst, die von dem Detektor stammen, wobei die Verarbeitungsvorrichtung mit mindestens einer Metallschicht (130) zum Schutz vor elektromagnetischer Strahlung bedeckt ist, die zwischen dem Detektor und der Verarbeitungsvorrichtung angeordnet ist, wobei die Metallschicht eine oder mehrere Öffnungen (135) aufweist, wobei die von der Metallschicht eingenommene Oberfläche größer ist als die von den Öffnungen eingenommene Gesamtfläche, wobei durch die Öffnungen tretende leitfähige Kontaktstücke (140) eine elektrische Verbindung zwischen der Verarbeitungsvorrichtung und dem Detektor ermöglichen, wobei die leitfähigen Kontaktstücke durch leitfähige Durchkontaktierungen (124) mit Kontakten der integrierten Schaltung (100) elektrisch verbunden sind, wobei die leitfähigen Kontaktstücke über Metallkontakte (150) mit dem Detektor elektrisch verbunden sind, wobei im Bereich der Öffnungen (135) der Metallschicht die leitfähigen Kontaktstücke von der Metallschicht (130) durch einen Zwischenraum getrennt sind, der ausreichend klein ist, um eine kapazitive Kopplung zwischen den leitfähigen Kontaktstücken und der Metallschicht (130) zu ermöglichen, **dadurch gekennzeichnet, dass** die Öffnungen (135) eine Verteilung aufweisen, die so vorgesehen ist, dass der Abstand zwischen zwei Öffnungen mindestens 5 mal größer als der Durchmesser der leitfähigen Kontaktstücke (140) ist, um die gegenseitige Kapazität zwischen den leitfähigen Kontaktstücken (140) auf null zu bringen.

2. Integrierte Schaltung nach Anspruch 1, enthaltend Mittel zum Vorspannen der Metallschicht (130).

3. Integrierte Schaltung nach Anspruch 1 oder 2, wobei der obere Teil der integrierten Schaltung mindestens eine isolierende Schicht (121) enthält, in der die leitfähigen Kontaktstücke angeordnet sind.

4. Integrierte Schaltung nach einem der Ansprüche 1 bis 3, wobei die Schutz-Metallschicht (130) an der Oberfläche der integrierten Schaltung angeordnet ist, wobei jedes leitfähige Verbindungskontaktstück (140) an der Oberfläche der integrierten Schaltung angeordnet ist.

5. Integrierte Schaltung nach einem der Ansprüche 1 bis 4, enthaltend ein Halbleitersubstrat, wobei die Signalverarbeitungsvorrichtung elektrische Komponenten umfasst, die in und über dem Halbleitersubstrat ausgebildet sind.

6. Integrierte Schaltung nach einem der Ansprüche 1 bis 5, wobei die Öffnungen und die leitfähigen Kontaktstücke, die in diesen Öffnungen angeordnet sind, im Wesentlichen zylindrische Formen haben.

7. Verfahren zum Prüfen einer integrierten Schaltung nach einem der Ansprüche 1 bis 6, umfassend die nachstehenden Schritte:
- Anlegen einer variablen Spannung an die Metallschicht, und
- Funktionsprüfung der Signalverarbeitungsvorrichtung.

8. Verfahren zum Erfassen einer elektromagnetischen Strahlung mittels einer integrierten Schaltung nach einem der Ansprüche 1 bis 6, darin bestehend, dass beim Betrieb des elektromagnetischen Strahlungsdetektors ein festes Potential an die Metallschicht angelegt wird.

9. Verfahren zum Erfassen einer elektromagnetischen Strahlung mittels einer integrierten Schaltung nach einem der Ansprüche 1 bis 6, darin bestehend, dass beim Betrieb des Strahlungsdetektors ein variables Potential an die Metallschicht angelegt wird, um die von dem elektromagnetischen Strahlungsdetektor gelieferten elektrischen Signale zu modulieren.

## Claims

1. An integrated circuit (100) assembled with an electromagnetic radiation detector (200), the integrated circuit comprising a device for processing signals from the detector, the processing device being covered with at least one protective metallic plate (130) against electromagnetic radiation, placed between said detector and said processing device, said conducting device including one or more opeings (135), the surface occupied by the metallic plate being more important than the total surface occupied by the openings, conducting pads (140) through the apertures providing an electrical connection between the processing device and the detector, the conducting pads (140) being electrically connected by conducting vias to contacts of the integrated circuit (100), the conducting pads (140) being electrically connected to the detector (200) by metallic contacts, wherein, at the openings (135) of the metallic layer (130), the conducting pads (140) and the metallic plate are separated from space sufficiently small to enable capacitive coupling between the conducting pads (140) and the metallic plate (130), **characterized in that** the openings (135) have an arrangement provided so that the spacing between two opening is at least 5 times higher than the diameter of the conducting pads so as to nullify the mutual capacitance between the conducting pads (140)

2. The integrated circuit according to claim 1, comprising means for biasing said metallic plate (130).

3. The integrated circuit according to claim 1 or 2, wherein said upper portion of the integrated circuit comprises at least one insulating layer (121) in which said conductive pads are placed.

4. The integrated circuit according to any of claims 1 to 3, wherein said metallic plate (130) is placed at the surface of the integrated circuit, each connection pad (140) being placed at the surface of the integrated circuit.

5. The integrated circuit according to any of claims 1 to 4, comprising a semiconducting substrate, the signal processing device comprising electrical components formed in and above the semiconducting substrate.

6. The integrated circuit according to any of the claims 1 to 5, wherein said openings and the conducting pads are placed in these openings have substantially cylindrical shapes.

7. A method for testing an integrated circuit according to any of the claims 1 to 6, comprising the following steps:
- applying a variable voltage on said metallic plate, and
- verifying the operation of the signal processing device.

8. A method for detecting electromagnetic radiation by means of a device according to any of the claims 1 to 6 consisting of applying a fixed potential on said conductive plate while operating the electromagnetic radiation detector.

9. A method for detecting electromagnetic radiation by means of a device according to any of the claims 1 to 6 consisting of applying a variable potential on said conductive plate while operating the radiation detector in order to modulate electrical signals delivered by the electromagnetic radiation detector.
